# EUROPEAN PATENT SPECIFICATION

(11) **EP 1 446 870 B1**
(45) Date of publication and mention of the grant of the patent: **16.02.2011**
(21) Application number: 02786305.9
(22) Date of filing: 08.11.2002
(51) Int. Cl.: H02P 9/10, H02H 9/04, H03F 1/52

(54) **TRANSIENT DAMPING ARRANGEMENT**
TRANSIENTENDÄMPFUNGSANORDNUNG
AGENCEMENT D'AMORTISSEMENT DE PHENOMENES TRANSITOIRES

(30) Priority: 08.11.2001 SE 0103721
(43) Date of publication of application: 18.08.2004
(73) Proprietor: Telefonaktiebolaget LM Ericsson (publ), 164 83 Stockholm (SE)
(72) Inventor: SVENSSON, Andréas, Richardson, TX 75080 (US)
(74) Representative: Kühn, Friedrich Heinrich
(86) International application number: PCT/SE2002/002030
(87) International publication number: WO 2003/041265

(56) References cited:
- US-A- 5 973 419
- SANDBERG M.: 'AC power conditioning', 1996, CRC PRESS, FLORIDA, ISBN 0-8493-8345-5 article WHITAKER Y.C.: 'The electronics handbook', pages 1024 - 1029, XP002960571
- PATENT ABSTRACTS OF JAPAN & JP 2000 139026 A (TOSHIBA CORP.) 16 May 2000

## Description

### TECHNICAL FIELD

The invention relates to an arrangement for damping transients that are generated by a complex load on its input terminals that are connected to a supply voltage.

### BACKGROUND OF THE INVENTION

In integrated circuits (IC), the silicon dies become more and more crowded in order to accommodate more functions and increase the operating speed. Hereby, the circuits require lower supply voltages at the same time as they consume more currents. Thus, the power consumption remains the same.

To save power, it is quite common today to turn off those parts of a system that are not used for the moment.

However, when high currents flow through inductances, e.g. conductors between current suppliers and current consumers, magnetic energy is accumulated in the inductances. When the currents stop to flow, voltage spikes are generated.

Moreover, when currents suddenly are drawn through inductances, the currents will increase in accordance with the equation ΔI = U × Δt/L, where I is the current, U is the voltage across the inductance, t is the time, and L is the inductance value. This will cause the current consumers to see voltage dips.

Thus, current consumers having such parasitic inductances in series will see voltage spikes and dips that will disturb the operation.

These voltage spikes and dips are normally called transients.

It is known to reduce transients by using complicated current supplies or large capacitors having very low equivalent series resistances and inductances. Complicated current supplies are expensive and so are large capacitors. Moreover, large capacitors occupy a lot of space and are sometimes very difficult to procure.

A transient load corrector for switching converters is also known from U.S. Patent No. 5,838,145.

### SUMMARY OF THE INVENTION

The object of the invention is to bring about a transient damping arrangement that is cheap to implement.

This is attained by the arrangement according to the invention for damping transients that are generated by a complex load on its input terminals that are connected to a first supply voltage, in that one input terminal is connected to an output terminal of a buffer amplifier, to the (+)-input terminal of a differential amplifier via a first resistor, and to the (-)-input terminal of the differential amplifier via a first capacitor, that the other input terminal is connected to the (+)-input terminal of the differential amplifier via a second resistor that is connected in parallel with a second capacitor, that the output terminal of the differential amplifier is connected to the input terminal of the buffer amplifier via a third capacitor, and to the (-)-input terminal of the differential amplifier via a third resistor, and that the buffer amplifier and the differential amplifier are connected with one supply voltage terminal to said other input terminal and with the other supply voltage terminal to a further input terminal that is connected to a potential that is higher than the potential that is connected to said one input terminal.

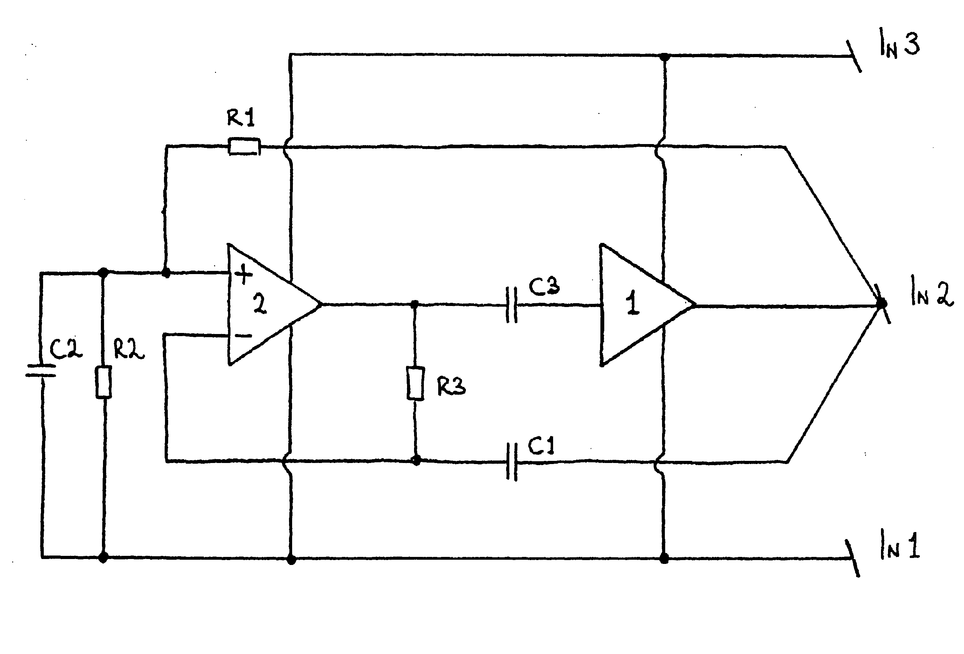

### BRIEF DESCRIPTION OF THE DRAWING

The invention will be described more in detail below with reference to the appended drawing on which the single figure is a circuit diagram of a transient damping arrangement according to the invention.

### DESCRIPTION OF THE INVENTION

The figure is a circuit diagram of a transient damping arrangement according to the invention for damping transients that are generated by a complex load (not shown) on its input terminals IN1, IN2. The input terminal IN1 is to be connected to a potential U1 and the input terminal IN2 is to be connected to a potential U2 that is higher than U1.

In accordance with the invention, the input terminal IN2 is connected to an output terminal of a buffer amplifier 1, to the (+)-input terminal of a differential amplifier 2 via a resistor R1, and to the (-)-input terminal of the differential amplifier 2 via a capacitor C1.

The input terminal IN1 is connected to the (+)-input terminal of the differential amplifier 2 via a resistor R2 that is connected in parallel with a capacitor C2.

The output terminal of the differential amplifier 2 is connected to the input terminal of the buffer amplifier 1 via a capacitor C3, and to the (-)-input terminal of the differential amplifier 2 via a resistor R3.

In accordance with the invention, the buffer amplifier 1 and the differential amplifier 2 are connected with one supply voltage terminal to the input terminal IN1 and with the other supply voltage terminal to an input terminal IN3 that is connected to a supply voltage U3 that is higher than U2.

To allow for both a negative and a positive swing on the output terminal of the differential amplifier 2, a lower voltage is generated on the (+)-input terminal of the differential amplifier 2 by means of the voltage divider R1, R2, C2. This lower voltage is the starting voltage of the differential amplifier 2.

R2 and C2 together act as a low pass filter that enables a voltage change on IN2 to reach the (-)-input terminal of the differential amplifier 2 earlier via C1 than the (+)-input terminal of the differential amplifier 2.

From a DC point of view, the output terminal of the differential amplifier 2 will be at the same DC value as the (-)-input terminal and the (+)-input terminal of the differential amplifier 2 in view of the fact that R3 is feedback connected to the (-)-input terminal.

C3 isolates the buffer amplifier 1 from the DC voltage from the differential amplifier 2 and transfers only AC signals that control the buffer amplifier 1 in order to damp voltage transients.

When a positive voltage spike appears between IN2 and IN1, this spike is transferred via C1 to the (-)-input terminal of the differential amplifier 2. The (+)-input terminal of the differential amplifier 2 is at a DC level somewhere between U2 and U1. When the (-)-input terminal of the differential amplifier 2 is lifted to a higher voltage than the (+)-input terminal, the differential amplifier 2 will output a negative signal to counteract the difference such that there will again be balance between the (-)-input terminal and the (+)-input terminal of the differential amplifier 2.

This negative signal is transferred via C3 to the buffer amplifier 1. The buffer amplifier 1 shunts the positive transient to In 1 until there is balance again between the (-)-input terminal and the (+)-input terminal of the differential amplifier 2.

In such a manner, the positive voltage spike is damped.

When a negative voltage dip appears between IN2 and IN1, this dip is transferred via C1 to the (-)-input terminal of the differential amplifier 2. The (+)-input terminal of the differential amplifier 2 is at a DC level somewhere between U2 and U1. When the (-)-input terminal of the differential amplifier 2 is lowered to a lower voltage than the (+)-input terminal, the differential amplifier 2 will output a positive signal to counteract the difference such that there will again be balance between the (-)-input terminal and the (+)-input terminal of the differential amplifier 2.

This positive signal is transferred via C3 to the buffer amplifier 1. The buffer amplifier 1 shunts the negative transient to In 3 until there is balance again between the (-)-input terminal and the (+)-input terminal of the differential amplifier 2.

In such a manner, the negative voltage dip is damped.

## Claims

1. n arrangement for damping transients that are generated by a complex load on its input terminals that are to be connected to a first supply voltage, wherein
- one input terminal (IN2) of the load is connected to an output terminal of a buffer amplifier (1), to the (+)-input terminal of a differential amplifier (2) via a first resistor (R1), and to the (-)-input terminal of the differential amplifier (2) via a first capacitor (C1),
- the other input terminal (IN1) of the load is connected to the (+)-input terminal of the differential amplifier (2) via a second resistor (R2) that is connected in parallel with a second capacitor (C2),
- the output terminal of the differential amplifier (2) is connected to the input terminal of the buffer amplifier (1) via a third capacitor (C3), and to the (-)-input terminal of the differential amplifier (2) via a third resistor (R3), and
- the buffer amplifier (1) and the differential amplifier (2) are connected with one supply voltage terminal to said other input terminal (IN1) of the load and with the other supply voltage terminal to a further input terminal (IN3) that is to be connected to a potential that is higher than the potential that is to be connected to said one input terminal (IN2).

## Patentansprüche

1. Anordnung zum Dämpfen von Transienten, die von einer komplexen Last an ihren Eingangsanschlüssen erzeugt werden, die mit einer ersten Versorgungsspannung zu verbinden sind, wobei
ein Eingangsanschluss (IN2) der Last mit einem Ausgangsanschluss einer Pufferverstärkers (1), mit dem (+)-Eingangsanschluss eines Differenzverstärkers (2) über einen ersten Widerstand (R1) und mit dem (-)-Eingangsanschluss des Differenzverstärkers (2) über einen ersten Kondensator (C1) verbunden wird,
der andere Eingangsanschluss (IN1) der Last mit dem (+)-Eingangsanschluss des Differenzverstärkers (2) über einen zweiten Widerstand (R2), der in Parallelschaltung mit einem zweiten Kondensator (C2) verbunden ist, verbunden wird,
der Ausgangsanschluss des Differenzverstärkers (2) mit dem Eingangsanschluss des Pufferverstärkers (1) über einen dritten Kondensator (C3) und mit dem (-)-Eingangsanschluss des Differenzverstärkers (2) über einen dritten Widerstand (R3) verbunden wird, und
der Pufferverstärker (1) und der Differenzverstärker (2) mit einem Versorgungsspannungsanschluss mit dem anderen Eingangsanschluss (IN1) der Last und mit dem anderen Versorgungsspannungsanschluss mit einem weiteren Eingangsanschluss (IN3), der mit einem Potenzial zu verbinden ist, das höher als das Potenzial ist, das mit dem einen Eingangsanschluss (IN2) zu verbinden ist, verbunden werden.

## Revendications

1. Agencement destiné à amortir les phénomènes transitoires générés par une charge complexe sur ses bornes d'entrée lesquelles doivent être connectées à une première tension d'alimentation, dans lequel :
une borne d'entrée (IN2) de la charge est connectée à une borne de sortie d'un amplificateur tampon (1), à la borne d'entrée positive (+) d'un amplificateur différentiel (2) par le biais d'une première résistance (R1), et à la borne d'entrée négative (-) de l'amplificateur différentiel (2) par le biais d'un premier condensateur (C1) ;
l'autre borne d'entrée (IN1) de la charge est connectée à la borne d'entrée positive (+) de l'amplificateur différentiel (2) par le biais d'une deuxième résistance (R2) laquelle est connectée en parallèle à un deuxième condensateur (C2) ;
la borne de sortie de l'amplificateur différentiel (2) est connectée à la borne d'entrée de l'amplificateur tampon (1) par l'intermédiaire d'un troisième condensateur (C3), et à la borne d'entrée négative (-) de l'amplificateur différentiel (2) par l'intermédiaire d'une troisième résistance (R3) ; et
l'amplificateur tampon (1) et l'amplificateur différentiel (2) sont connectés, avec une borne de tension d'alimentation, à ladite autre borne d'entrée (IN1) de la charge et, avec l'autre borne de tension d'alimentation, à une borne d'entrée supplémentaire (IN3) destinée à être connectée à un potentiel lequel est supérieur au potentiel destiné à être connecté à ladite une borne d'entrée (IN2).
